# EUROPEAN PATENT APPLICATION

(11) **EP 4 113 758 A1**
(43) Date of publication of application: **04.01.2023**
(21) Application number: 21760585.6
(22) Date of filing: 21.01.2021
(51) Int. Cl.: H01R 43/16, G01R 1/067, H01R 13/15, H01R 13/24

(54) **SPRING CONNECTOR, CONNECTOR, AND METHOD FOR MANUFACTURING SPRING CONNECTOR**

(30) Priority: 26.02.2020 JP 2020030039
(71) Applicant: YOKOWO CO., LTD., Kita-ku Tokyo 114-8515 (JP)
(72) Inventor: KOBAYASHI, Fumikazu, Tomioka-Shi, Gunma 370-2495 (JP); MORITA, Nozomu, Tokyo 114-8515 (JP)
(74) Representative: Hoefer & Partner Patentanwälte mbB
(86) International application number: PCT/JP2021/001986
(87) International publication number: WO 2021/171844

(57) **Abstract**

A spring connector (10) includes: an insulating housing (1) having a through hole (11); a conductor (2) disposed on one end side of the through hole (11); and a conductive external contact pin (3) disposed on another end side of the through hole. The housing (1) has an opening portion on the other end side of the through hole (11). A part of the through hole (11) and a part of the conductor (2) form an internal space. The external contact pin (3) includes a tip end portion (311) configured to protrude from the opening portion and a main body portion (33) positioned in the through hole. The external contact pin (3) and the conductor (2) are configured to be switched between a non-conductive state and a conductive state by moving the tip end portion (311) of the external contact pin in a backward direction opposite to a protruding direction in which the tip end portion (311) protrudes from the opening portion.

## Description

### TECHNICAL FIELD

The present invention relates to a spring connector, a connector, and a method for manufacturing a connector.

### BACKGROUND ART

In the related art, a spring connector is known in which a conductive external contact pin (also referred to as a contact pin), a conductive spring, or the like are accommodated in a conductive tube (see Patent Literature 1).

### CITATION LIST

### PATENT LITERATURE

Patent Literature 1: JP-A-2004-247170

### SUMMARY OF INVENTION

### TECHNICAL PROBLEM

However, in the configuration of the spring connector in the related art in which the conductive external contact pin, the conductive spring, or the like are accommodated in the conductive tube, since the external contact pin and the tube are always in contact with each other, electrical connection is ensured not only when in use. A state where the electrical connection is ensured is a state where the tube positioned on one end side and the external contact pin positioned on the other end side are conducted, that is, a state where contact points of the spring connector are conducted.

An object of the present invention is to provide a technique of a spring connector capable of cutting off electrical connection when an external contact pin is not pushed, and capable of performing the electrical connection when the external contact pin is pushed.

### SOLUTION TO PROBLEM

According an aspect of the present invention, there is provided a spring connector including: an insulating housing having a through hole; a conductor disposed on one end side of the through hole; and a conductive external contact pin disposed on another end side of the through hole. The housing has an opening portion on the other end side of the through hole. A part of the through hole and a part of the conductor form an internal space. The external contact pin includes a tip end portion configured to protrude from the opening portion and a main body portion positioned in the through hole. The external contact pin and the conductor are configured to be switched between a non-conductive state and a conductive state by moving the tip end portion of the external contact pin in a backward direction opposite to a protruding direction in which the tip end portion protrudes from the opening portion.

According to this aspect, when the external contact pin moves in the backward direction, the external contact pin and the conductor are switched between the non-conductive state and the conductive state. Therefore, it is possible to provide a technique of the spring connector capable of cutting off electrical connection when the external contact pin is not pushed and capable of performing the electrical connection when the external contact pin is pushed.

### BRIEF DESCRIPTION OF DRAWINGS

[FIG. 1] FIG. 1 is a longitudinal cross-sectional view illustrating a configuration example of a spring connector according to a first embodiment in a state where an external contact pin is not pushed.
[FIG. 2] FIG. 2 is a longitudinal cross-sectional view illustrating a configuration example of the spring connector according to the first embodiment in a state where the external contact pin moves backward.
[FIG. 3] FIG. 3 is a longitudinal cross-sectional view illustrating a configuration example of a spring connector according to a second embodiment.
[FIG. 4] FIG. 4 is a longitudinal cross-sectional view illustrating a configuration example of a spring connector according to a third embodiment.
[FIG. 5] FIG. 5 is a longitudinal cross-sectional view illustrating a configuration example of a spring connector according to a first modification of the third embodiment.
[FIG. 6] FIG. 6 is a longitudinal cross-sectional view illustrating a configuration example of a spring connector according to a second modification of the third embodiment.
[FIG. 7] FIG. 7 is a longitudinal cross-sectional view illustrating a configuration example of a spring connector according to a third modification of the third embodiment.
[FIG. 8] FIG. 8 is a longitudinal cross-sectional view illustrating a configuration example of a connector according to a fourth embodiment.
[FIG. 9] FIG. 9 is a flowchart illustrating a method for manufacturing a connector.

### DESCRIPTION OF EMBODIMENTS

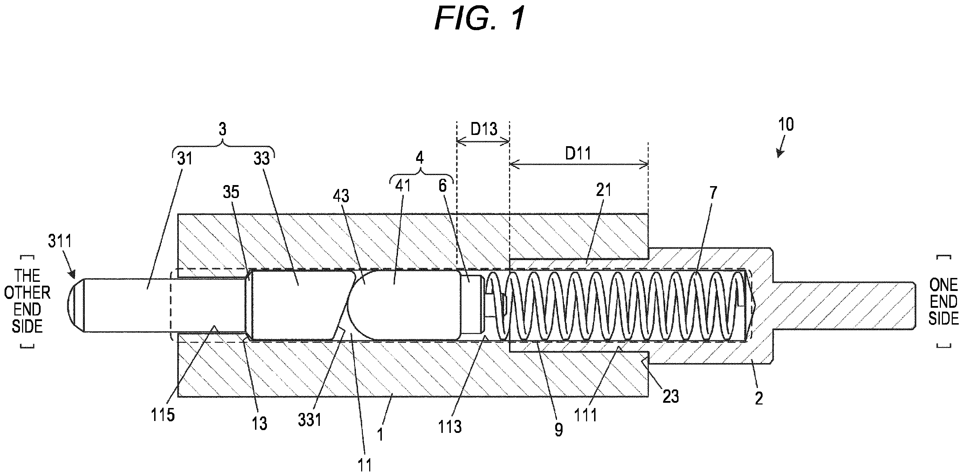

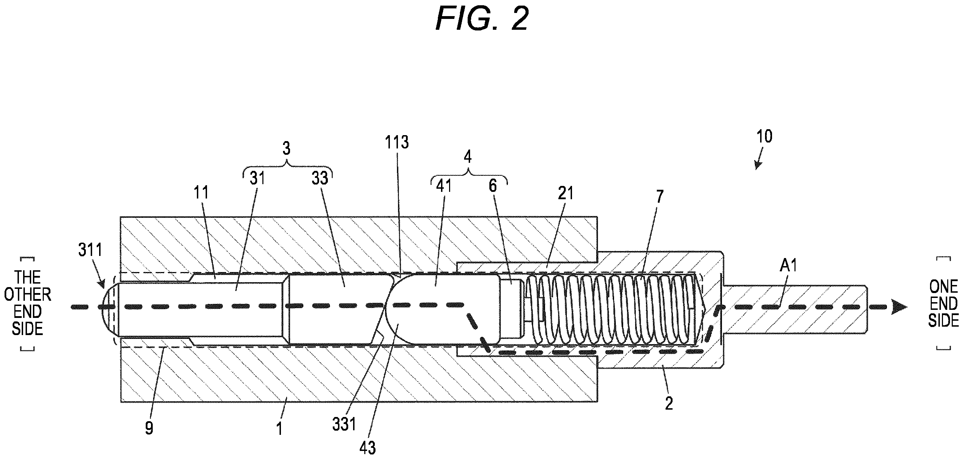

Preferred embodiments of the present invention will be described. The present invention is not limited to the embodiments described below, and modes to which the present invention can be applied are not limited to the following embodiments. In the description of the drawings, the same portions are denoted by the same reference signs. One end side of a spring connector 10 is described as a side where a conductor (for example, a tube 2) is provided, and the other end side is described as a side where an external contact pin 3 is provided. The one end refers to an end portion in a direction from the external contact pin 3 toward the conductor (for example, the tube 2), and the other end refers to an end portion in a direction from the conductor (for example, the tube 2) toward the external contact pin 3. As illustrated in FIG. 1, a right side is the one end side, and a left side is the other end side. In FIGS. 2 to 8, similarly to FIG. 1, the right side is the one end side, and the left side is the other end side.

### (First Embodiment)

FIG. 1 is a longitudinal cross-sectional view illustrating a configuration example of the spring connector 10 according to a first embodiment, and illustrates an internal configuration by cutting out a housing 1 and the tube 2. FIG. 1 illustrates a non-pushed-in state where the external contact pin 3 is not pushed toward the one end side. As illustrated in FIG. 1, the spring connector 10 of the first embodiment includes a housing 1, a tube 2, an external contact pin 3, an internal contact 4, and a spring 7 as an elastic member.

The housing 1 is insulating and made of, for example, a resin, insulating metal, or the like as a material. A method for manufacturing the housing 1 can be appropriately selected. For example, in addition to a method in which a resin is poured into a mold and molded, a processing method by cutting or shaping can be adopted. In addition, a method in which an insulating coating treatment is applied on a metal housing may be adopted.

The housing 1 includes an internal space 9 and a through hole 11 forming a part of the internal space 9. On an inner peripheral surface of the through hole 11, inner diameter portions of three steps are formed in an axial direction (a left-right direction in FIG. 1) of the spring connector 10, and a step is formed between the inner diameter portions. An inner diameter portion having the largest inner diameter positioned on the one end side of the inner diameter portions of the three steps is a first step portion 111. The smallest inner diameter portion positioned on the other end side is a third step portion 115. An inner diameter portion positioned between the first step portion 111 and the third step portion 115 is a second step portion 113. An inner diameter of the second step portion 113 is smaller than the inner diameter of the first step portion 111 and larger than the inner diameter of the third step portion 115. The first step portion 111 forms a fitting portion with an insertion portion 21 to be described. A step 13 between the second step portion 113 and the third step portion 115 forms a locking portion with the external contact pin 3. The step 13 suppresses the external contact pin 3 from coming off the housing 1.

A size relationship between the inner diameters of the first step portion 111, the second step portion 113, and the third step portion 115 is an example, and other relationships may be used. However, in a case where the come-off suppression of the external contact pin 3 from the housing 1 is realized by the step 13, the inner diameter of the third step portion 115 needs to be smaller than the inner diameter of the second step portion 113.

The tube 2 is conductive and made of, for example, copper, a copper alloy, or the like as a material. A method for manufacturing the tube 2 can be appropriately selected. For example, the tube 2 can be manufactured by forging or cutting. The tube 2 includes the tubular insertion portion 21 having an open end portion. The insertion portion 21 is formed by hole machining using a drill or the like. Alternatively, the tube 2 may be formed by press working using sheet metal, or may be manufactured by casting in which metal is poured into a mold and molded. The tube 2 may be manufactured by casting in which a metal is poured into a mold and molded. The method in which a surface of a molded product made by pouring a resin into a mold is subjected to metal plating, may be adopted.

The insertion portion 21 is inserted into one end side of the through hole 11 and fitted into the first step portion 111 on the one end side. An inner peripheral surface of the insertion portion 21 forms a smooth cylindrical inner curved surface continuous with an inner peripheral surface of the second step portion 113 of the housing 1. The internal space 9 is formed by the inner peripheral surface of the through hole 11 and the inner peripheral surface of the insertion portion 21 positioned near one end of the through hole 11. In the first embodiment, the internal space 9 is formed by a portion related to the housing 1 and a portion related to the tube 2. The portion related to the housing 1 is an inner peripheral surface from the other end of the through hole 11 to the second step portion 113. The portion related to the tube 2 is the inner peripheral surface of the insertion portion 21 of the tube 2, which is continuous with the inner peripheral surface of the second step portion 113. The internal space 9 corresponds to a range surrounded by a broken line in FIG. 1. An inner diameter of the insertion portion 21 may be larger than the inner diameter of the second step portion 113.

A step 23 is formed on an outer peripheral surface of the tube 2 in accordance with a length of the insertion portion 21 (a distance from an end portion on the one end side of the through hole 11 to an end portion on one end side of the second step portion 113) D11. In a state where the insertion portion 21 is fitted into the first step portion 111 and the inner peripheral surface of the insertion portion 21 and the inner peripheral surface of the second step portion 113 are continuous, the step 23 abuts on one end surface of the housing 1 on a side where the insertion portion 21 is inserted. The tube 2 is fixed to the housing 1 by, for example, adhering the abutting portion. The insertion portion 21 may be fixed by being press-fitted into the first step portion 111.

The external contact pin 3 is conductive and made of, for example, copper, a copper alloy, or the like as a material. As a method for manufacturing the external contact pin 3, the same manufacturing method as that of the tube 2 can be selected. A tip end portion 311 of the external contact pin 3 protrudes from the other end of the through hole 11, which is an opening portion on the other end side of the internal space 9. The external contact pin 3 includes a small diameter portion 31 having a protruding shape and a large diameter portion 33 having a diameter larger than that of the small diameter portion 31. The tip end portion 311, which is a tip end of the small diameter portion 31, is a contact portion that is in contact with a terminal to be connected (not illustrated). The small diameter portion 31 and the large diameter portion 33 are connected in a stepped manner. A tapered step surface 35 between the small diameter portion 31 and the large diameter portion 33 abuts on the step 13 of the through hole 11, and the external contact pin 3 is suppressed from coming off the through hole 11. Accordingly, the external contact pin 3 does not come off the internal space 9, and a part of the external contact pin 3 is positioned in the internal space 9. Therefore, even in a state where the small diameter portion 31 protrudes from the other end of the through hole 11, the large diameter portion 33 is positioned in the second step portion 113 and positioned in the through hole 11. The large diameter portion 33 can also be referred to as a main body portion of the external contact pin 3. Note that the come-off suppression of the external contact pin 3 from the housing 1 may not be realized by the step 13, and may be realized by engagement with a hook claw or the like. In this case, the inner diameter of the second step portion 113 may be equal to the inner diameter of the third step portion 115, or the inner diameter of the second step portion 113 may be larger than the inner diameter of the third step portion 115.

In the external contact pin 3, a rear end surface of the large diameter portion 33 forms an inclined surface 331 inclined with respect to an axial direction of the internal space 9.

The internal contact 4 includes an internal contact pin 41 as an internal contact portion in contact with the external contact pin 3, and an insulator 6. The internal contact pin 41 and the insulator 6 may be adhered to each other to form an integral structure, or may be separate bodies that can be separated. Further, the insulator 6 may be omitted by insulating coating a surface of one end side of the internal contact pin 41.

The internal contact pin 41 is conductive and made of, for example, copper, a copper alloy, or the like as a material. As a method for manufacturing the internal contact pin 41, a manufacturing method similar to that of the external contact pin 3 or the tube 2 can be selected. The internal contact pin 41 is positioned between the external contact pin 3 and the insulator 6, and comes into contact with the external contact pin 3 by biasing of the spring 7. An end portion of the internal contact pin 41 on a side in contact with the inclined surface 331, which is a rear end surface of the external contact pin 3, forms a convex portion 43. The convex portion 43 has, for example, a curved shape such as a bow-shaped rotating body shape illustrated in FIG. 1. In addition, the curved shape of the convex portion 43 may be a conical shape or the like.

The insulator 6 is insulating and made of, for example, a resin, insulation corresponding metal as a material. The insulator 6 is positioned between the external contact pin 3 and the spring 7 and between the internal contact pin 41 and the spring 7, and is biased toward the internal contact pin 41 by the biasing of the spring 7. The internal contact pin 41 and the spring 7 are not in contact with each other by the insulator 6, and the internal contact pin 41 and the spring 7 are insulated from each other. Therefore, conduction between the internal contact pin 41 and the spring 7 and conduction between the external contact pin 3 and the spring 7 can be suppressed.

The spring 7 is, for example, a coil spring formed of a piano wire or a stainless wire material. The spring 7 is positioned in the internal space 9 and biases the external contact pin 3 via the internal contact 4. Specifically, the spring 7 biases the external contact pin 3 in a protruding direction in which the tip end portion 311 protrudes from the other end of the through hole 11. The spring 7 of the first embodiment is conductive, but may be insulating.

FIG. 2 is a longitudinal cross-sectional view illustrating the spring connector 10 in a state where the tip end portion 311 is pushed toward the one end side from the state of FIG. 1 and the external contact pin 3 moves backward into the internal space 9. FIG. 2 illustrates the spring connector 10 when the tip end portion 311 of the external contact pin 3 is pushed to a vicinity of the opening portion on the other end side of the internal space 9. The spring connector 10 is used by pushing the terminal to be connected against the tip end portion 311 of the external contact pin 3 to push the tip end potion 311 and to push the external contact pin 3 into the through hole 11 as illustrated in FIG. 2.

In the state of FIG. 1 where the external contact pin 3 is not pushed toward the one end side and not moved in a backward direction, the large diameter portion 33 of the conductive outer contact pin 3 and the internal contact pin 41 are positioned in the second step portion 113 in the through hole 11 of the housing 1. The conductive external contact pin 3 and the internal contact pin 41 are at non-contact positions with the conductive tube 2. Therefore, when the external contact pin 3 is at the position of FIG. 1 (hereinafter, referred to as "non-pushed-in position"), the external contact pin 3 and the tube 2 are in a non-conductive state.

On the other hand, in the state of FIG. 2 where the external contact pin 3 is pushed in the backward direction and moved by a predetermined amount, a part of the small diameter portion 31 of the external contact pin 3 is also positioned in the second step portion 113 in the through hole 11 of the housing 1. At least a part of the internal contact pin 41 is positioned in the insertion portion 21 of the tube 2 and is in contact with the tube 2. The internal contact pin 41 is interposed between the external contact pin 3 and the tube 2 so as to electrically conduct the external contact pin 3 and the tube 2. Therefore, when the external contact pin 3 is in the position of FIG. 2 (hereinafter, referred to as a "backward position"), the external contact pin 3 and the tube 2 are in a conductive state.

In the conductive state, as indicated by a broken line arrow A1 in FIG. 2, a current from the tip end portion 311 of the external contact pin 3 flows to the internal contact pin 41, and flows to the tube 2 in contact with the internal contact pin 41. At this time, since the insulator 6 is interposed between the internal contact pin 41 and the spring 7, the internal contact pin 41 and the spring 7 are electrically not conducted.

In the spring connector 10 of the first embodiment, the external contact pin 3 and the tube 2 are in the non-conductive state when the external contact pin 3 is in the non-pushed-in state, and are switched to the conductive state in a process in which the external contact pin 3 moves from the non-pushed-in position to the backward position. Specifically, when the other end portion of the internal contact pin 41 exceeds a boundary (hereinafter, referred to as a "switching boundary") between the inner peripheral surface of the second step portion 113 and the inner peripheral surface of the insertion portion 21 in a process in which the external contact pin 3 moves by a distance equal to or longer than a distance D13 in the backward direction, the internal contact pin 41 comes into contact with the inner peripheral surface of the insertion portion 21. At this timing, the external contact pin 3 and the tube 2 are brought into the conductive state from the initial non-conductive state.

As described above, in the spring connector 10 of the first embodiment, when the tip end portion 311 of the external contact pin 3 is not pushed toward the one end side, the external contact pin 3 and the tube 2 are in the non-conductive state, and when the tip end portion 311 is pushed and the external contact pin 3 is pushed by the predetermined amount from the opening portion on one end side of the internal space 9, the state is switched to the conductive state. In other words, in the spring connector 10, when the external contact pin 3 is not stroked by the predetermined amount, the external contact pin 3 and the tube 2 are not conducted. Therefore, it is possible to realize a configuration in which the electrical connection is cut off when the external contact pin 3 is not pushed by the predetermined amount, and the electrical connection is performed when the external contact pin 3 is pushed by the predetermined amount. Further, since the electrical connection is cut off when the external contact pin 3 is at the non-pushed-in position, the conduction does not occur in a case where conductive foreign matter is simply in contact with the tip end portion 311 or the like, and safety can be improved.

According to the spring connector 10 of the first embodiment, it is possible to variably set a movement amount in the backward direction in which the conductive state between the external contact pin 3 and the tube 2 is switched. In FIG. 1, the movement amount is indicated as the distance D13, but the movement amount can be set by changing the position of the switching boundary in the internal space 9. However, the position of the switching boundary is determined, and a length of the insertion portion 21 and the length of the first step portion 111 are defined such that the internal contact pin 41 does not come into contact with the inner peripheral surface of the insertion portion 21 when the external contact pin 3 is at the non-pushed-in position, and the internal contact pin 41 comes into contact with the inner peripheral surface of the insertion portion 21 when at least the external contact pin 3 is in the backward position. It is possible to appropriately adjust the movement amount according to an application, such as when the movement amount is small and the tip end portion 311 is pushed, the state is immediately switched to the conductive state, and when the movement amount is large and the tip end portion 311 is not deeply pushed, the state is not switched to the conductive state.

The spring connector 10 of the first embodiment includes the internal contact 4 including the internal contact pin 41 and the insulator 6. Specifically, the internal contact pin 41 is disposed between the external contact pin 3 and the spring 7, and the insulator 6 is interposed between the internal contact pin 41 and the spring 7. Accordingly, the conduction between the internal contact pin 41 and the spring 7 can be suppressed.

When the tip end portion 311 is pushed and the external contact pin 3 is pushed from the opening portion on the other end side of the internal space 9, the reaction force of the elastically deforming spring 7 is applied to the internal contact 4. Then, the convex portion 43 of the internal contact pin 41 rolls on the inclined surface 331 of the external contact pin 3, and the internal contact pin 41 is inclined with respect to the axial direction of the internal space 9 (the left-right direction in FIG. 1), whereby a part of a side surface thereof is stably pushed against an inner peripheral surface of the internal space 9. A reaction force of the spring 7 is applied from the convex portion 43 to the inclined surface 331. Then, since a normal direction of the inclined surface 331 is inclined with respect to the axial direction of the internal space 9, a side surface of the large diameter portion 33 is stably pushed against the inner peripheral surface of the internal space 9.

Therefore, the number of contact points (internal contact points) at which the internal contact pin 41 and the external contact pin 3 are stably in contact with the inner peripheral surface of the internal space 9 is increased, and a contact posture between the internal contact pin 41 and the external contact pin 3 is stabilized, and reliable contact between the internal contact pin 41 and the external contact pin 3 is maintained. According to this configuration, the external contact pin 3 and the tube 2 can be reliably conducted.

An end surface on one end side of the external contact pin 3 is referred to as the inclined surface 331, and an end portion on the other end side of the internal contact pin 41 is referred to as the convex portion 43. The configuration may be as follows. An end portion of the external contact pin 3 on the one end side in contact with the internal contact pin 41 is formed as a convex shape. An end portion of the internal contact pin 41 on the other end side in contact with the external contact pin 3 is defined as an end surface of the inclined surface. Even in this case, the same operational effect can be obtained.

According to the spring connector 10 of the first embodiment, the internal space 9 is formed by the through hole 11 of the housing 1 and the insertion portion 21 of the tube 2. The external contact pin 3, the internal contact pin 41, and the spring 7 are positioned in the internal space 9. A spring connector in the related art accommodates an external contact pin, a spring, and the like in a conductive tube. In the spring connector 10 of the first embodiment, the internal space 9 accommodating the external contact pin 3, the spring 7, and the like is formed by the through hole 11 of the housing 1 and the insertion portion 21 of the tube 2. Therefore, a length of the tube (tube length, length in the axial direction) can be shortened as compared with a length of the tube in the spring connector in the related art. Accordingly, it is possible to facilitate the hole machining for forming the insertion portion 21 and plating processing on the inner peripheral surface of the insertion portion 21, and it is possible to improve workability of the tube 2. Further, surface roughness at the time of the hole machining can be improved. When the surface roughness is improved, the adhesion of the plating is increased, and plating quality, sliding resistance, and wear resistance are improved.

On the other hand, the tube 2 is restricted to a tube length that can be manufactured due to characteristics such as the hole machining and the plating processing. Accordingly, a pin length of the external contact pin 3 is also restricted. However, since the internal space 9 is formed by the through hole 11 of the housing 1 and the insertion portion 21 of the tube 2 in the spring connector 10 of the first embodiment, it is possible to flexibly cope with an increased height compared to the configuration in the related art, and it is possible to easily increase a stroke length of the external contact pin 3.

In the spring connector having the configuration in the related art in which the external contact pin, the spring, and the like are accommodated in the tube, it is necessary to crimp the opening end of the tube at the time of manufacturing in order to suppress the external contact pin from coming off the tube. However, a crimping portion formed at the open end of the tube needs to be thin for crimping, and has a lower strength than tube portions other than the crimping portion. Therefore, in the spring connector having the configuration in the related art, the crimping portion may be damaged when a strong external force is applied. Further, there is a demand for a crimping technique that suppresses the external contact pin 3 from sliding or sticking.

On the other hand, the housing 1 of the spring connector 10 of the first embodiment is made of a resin, and any shape can be easily manufactured by injection molding or the like. The housing 1 provided with the through hole 11 having steps is manufactured and prepared, and the external contact pin 3 is inserted into the through hole 11 so as to make the tip end portion 311 protrude from the one end side. At this time, the step surface 35 of the external contact pin 3 abuts on the step 13 between the second step portion 113 and the third step portion 115, so that the external contact pin 3 is suppressed from coming off. Thereafter, the internal contact 4 is inserted, and the spring 7 is inserted after the internal contact 4 is inserted. After the spring 7 is inserted, the insertion portion 21 of the tube 2 is inserted, and the tube 2 is fixed to the housing 1 to assemble the spring connector 10. In the manufacture of the spring connector 10, a crimping process is not necessary.

Accordingly, since the crimping processing of the tip end of the tube is not required, a manufacturing process is simplified and the assembly is facilitated. Further, since the crimping portion of the tube is eliminated, strength is improved. That is, since a part of the resin housing 1 is used instead of the crimping portion of the tube, a thickness is increased, and a proof stress against an external force is improved. By shortening the tube length, an improvement in performance of the spring connector 10 is also expected.

### (Second Embodiment)

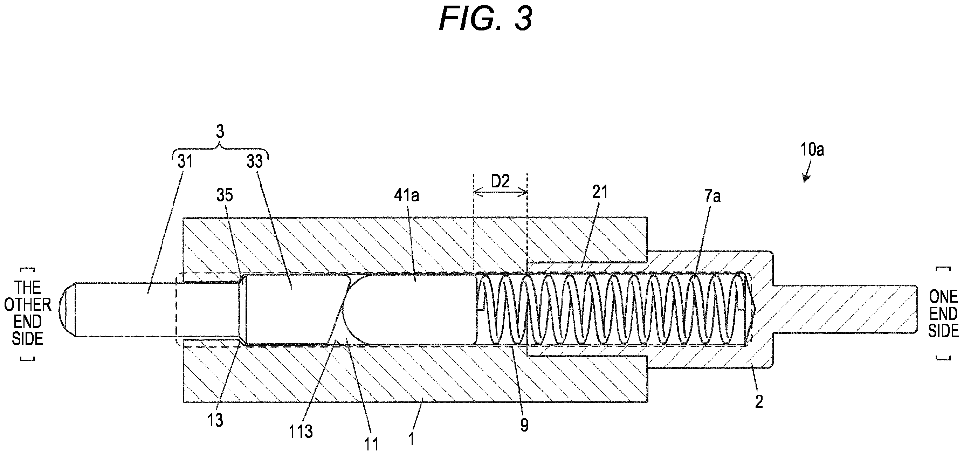

FIG. 3 is a longitudinal cross-sectional view illustrating a configuration example of a spring connector 10a according to a second embodiment, and illustrates the spring connector 10a in a state where the external contact pin 3 protrudes (the external contact pin 3 is at a non-pushed-in position). The spring connector 10a of the second embodiment includes an internal contact pin 41a as an internal contact, and has a configuration in which the insulator of the first embodiment is omitted. In FIG. 3, the same components as those of the first embodiment and the like are denoted by the same reference signs.

As illustrated in FIG. 3, the spring connector 10a of the second embodiment includes the housing 1, the tube 2, the external contact pin 3, an internal contact pin 41a, and a spring 7a.

The internal contact pin 41a is positioned between the external contact pin 3 and the spring 7a.

The spring 7a is, for example, an insulating coil spring made of a resin, insulating metal, or the like. A coil spring made of metal may be subjected to an insulating coating treatment. The spring 7a is positioned in the internal space 9 and biases the external contact pin 3 in the protruding direction via the internal contact pin 41.

In the spring connector 10a, the conductive outer contact pin 3 and the internal contact pin 41a are positioned in the second step portion 113 in the through hole 11 when the external contact pin 3 is in a state of FIG. 3 in which the external contact pin 3 is not pushed toward the one end side. The conductive external contact pin 3 and the internal contact pin 41a are in non-contact positions with the conductive tube 2. Therefore, the external contact pin 3 and the tube 2 are in a non-conductive state. On the other hand, when the external contact pin 3 is pushed toward the one end side and moves in a backward direction by a distance D2 or more, the internal contact pin 41a comes into contact with an inner peripheral surface of the insertion portion 21, and the external contact pin 3 and the tube 2 are switched to a conductive state.

According to the spring connector 10a of the second embodiment, the same effects as those of the first embodiment can be achieved. Further, since the spring 7a itself can be made to be insulating, the insulator 6 is not required.

### (Third Embodiment)

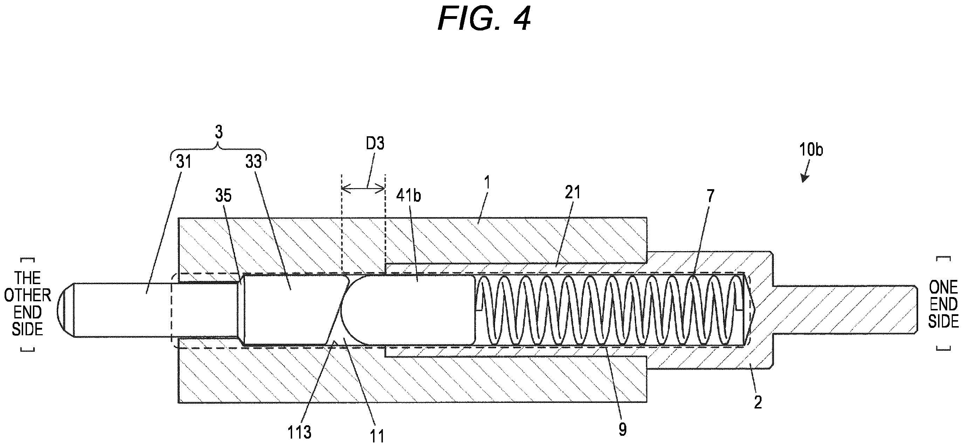

FIG. 4 is a longitudinal cross-sectional view illustrating a configuration example of a spring connector 10b according to a third embodiment, and illustrates the spring connector 10b in a state where the external contact pin 3 protrudes (the external contact pin 3 is at a non-pushed-in position). The spring connector 10b of the third embodiment has a configuration in which the internal contact pin in the configuration of the second embodiment is made to be insulating, and the internal contact pin of the second embodiment is replaced with an insulating one. In FIG. 4, the same components as those of the first embodiment and the second embodiment are denoted by the same reference signs.

As illustrated in FIG. 4, the spring connector 10b of the third embodiment includes the housing 1, the tube 2, the external contact pin 3, an internal contact pin 41b, and the spring 7.

The internal contact pin 41b is insulating and made of, for example, a resin, insulating metal, or the like as a material.

The conductive coil spring described in the first embodiment, or the insulating coil spring described in the second embodiment may be used as the spring 7. The spring 7 is positioned in the internal space 9 and biases the external contact pin 3 in a protruding direction via the internal contact pin 41b.

In the spring connector 10b, a dimension of each portion is also defined such that a state between the external contact pin 3 and the tube 2 is switched from a non-conductive state to a conductive state in a process in which the external contact pin 3 moves from the non-pushed-in position to a backward position. In the third embodiment, since the internal contact pin 41b is insulating, a switching boundary is in a vicinity of a center of the internal space 9. Therefore, when the external contact pin 3 is at the non-pushed-in position as illustrated in FIG. 4, the internal contact pin 41b is positioned in the insertion portion 21. The large diameter portion 33 of the conductive external contact pin 3 is positioned in the second step portion 113 in the through hole 11. In this state, the external contact pin 3 and the tube 2 are in the non-conductive state.

On the other hand, when the external contact pin 3 is pushed toward one end side and moves in a backward direction by a distance D3 or more, the large diameter portion 33 of the external contact pin 3 comes into contact with an inner peripheral surface of the insertion portion 21, and the external contact pin 3 and the tube 2 are switched to the conductive state.

According to the spring connector 10b of the third embodiment, the same effects as those of the first embodiment can be achieved.

Several modifications of the spring connector 10b of the third embodiment can be considered.

### (First Modification of Third Embodiment)

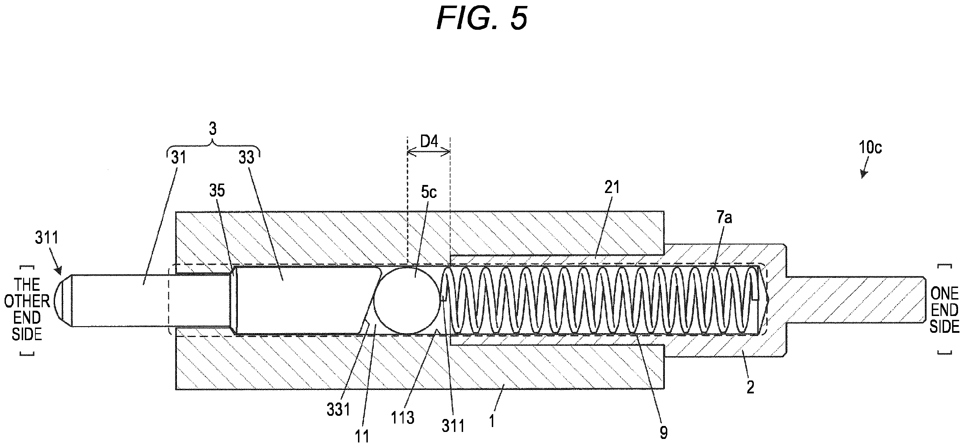

FIG. 5 is a longitudinal cross-sectional view illustrating a configuration example of a spring connector 10c according to a first modification of the third embodiment, and illustrates the spring connector 10c in a state where the external contact pin 3 protrudes (the external contact pin 3 is at a non-pushed-in position). The spring connector 10c includes a metal ball 5c instead of the internal contact pin 41b of the third embodiment. The spring 7 of the third embodiment is formed as the insulating spring 7a described in the second embodiment.

The metal ball 5c is a conductive sphere (for example, a steel ball). It is also possible to use a sphere made of an insulating material (for example, a resin, insulating metal, or the like), the surface of which is metal-plated. The metal ball 5c is located between the external contact pin 3 and the spring 7a in the internal space 9. In the state of FIG. 5 in which the external contact pin 3 is at the non-pushed-in position, the metal ball 5c is in contact with the inclined surface 331 of the external contact pin 3, the tip end portion 311 of the spring 7a, and an inner peripheral surface of the through hole 11 (the second step portion 113) forming the internal space 9. On the other hand, when the external contact pin 3 is in a backward position, the metal ball 5c is in contact with the inclined surface 331 of the external contact pin 3, the tip end portion 311 of the spring 7a, and an inner peripheral surface of the insertion portion 21 forming the internal space 9.

The spring 7a is positioned in the internal space 9 and biases the external contact pin 3 in a protruding direction via the metal ball 5c.

In the spring connector 10c, the conductive external contact pin 3 and the metal ball 5c are positioned in the second step portion 113 in the through hole 11 when the external contact pin 3 is at the non-pushed-in position as illustrated in FIG. 5. Therefore, the external contact pin 3 and the tube 2 are in a non-conductive state. On the other hand, when the external contact pin 3 is pushed toward one end side and moves in a backward direction by a distance D4 or more, the metal ball 5c comes into contact with the inner peripheral surface of the insertion portion 21, and the external contact pin 3 and the tube 2 are switched to a conductive state.

Since the metal ball 5c is interposed between the external contact pin 3 and the spring 7a, stable conduction between the external contact pin 3 and the tube 2 can be ensured. Specifically, when the tip end portion 311 is pushed and the external contact pin 3 is pushed in the backward direction, a reaction force of the elastically deformed spring 7 is applied to the metal ball 5c. Then, the metal ball 5c rolls along the inclined surface 331 of the external contact pin 3, and is stably pushed against an inner peripheral surface of the internal space 9. The reaction force of the spring is also applied from the metal ball 5c to the inclined surface 331. Then, since a normal direction of the inclined surface 331 is inclined with respect to an axial direction of the internal space 9, a side surface of the large diameter portion 33 is stably pushed against the inner peripheral surface of the internal space 9.

Therefore, the number of contact points (internal contact points) at which the metal ball 5c and the external contact pin 3 are stably in contact with the inner peripheral surface of the internal space 9 is increased, and a contact posture between the metal ball 5c and the external contact pin 3 is stabilized, and reliable contact between the metal ball 5c and the external contact pin 3 is maintained. According to this configuration, the external contact pin 3 and the tube 2 can be reliably conducted.

### (Second Modification of Third Embodiment)

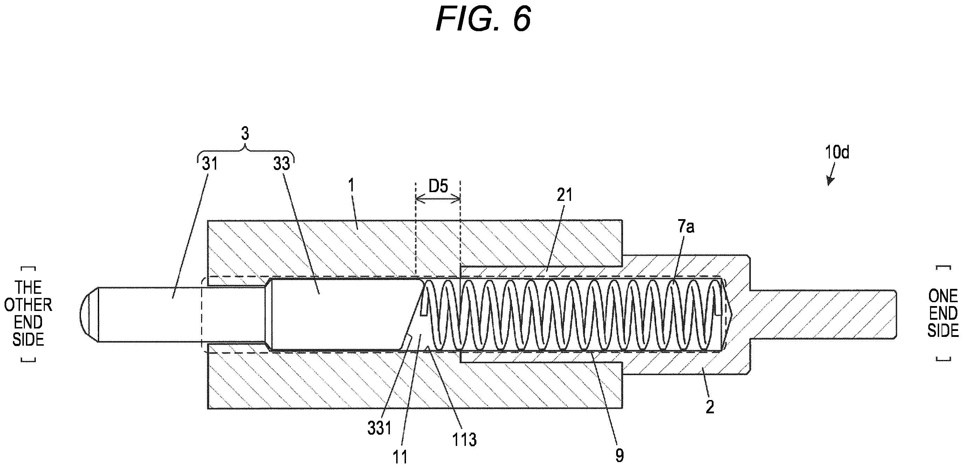

FIG. 6 is a longitudinal cross-sectional view illustrating a configuration example of a spring connector 10d according to a second modification of the third embodiment, and illustrates a spring connector 10d in a state where the external contact pin 3 protrudes (the external contact pin 3 is at a non-pushed-in position). The spring connector 10d has a configuration in which the internal contact pin 41b of the third embodiment is omitted and the spring 7a of the second embodiment is adopted.

The external contact pin 3 is disposed in the internal space 9 and is in direct contact with a tip end portion of the spring 7a.

The spring 7a is positioned the internal space 9 and directly biases the external contact pin 3 in a protruding direction.

In the spring connector 10d, the large diameter portion 33 of the conductive external contact pin 3 is positioned in the second step portion 113 in the through hole 11 when the external contact pin 3 is at the non-pushed-in position as illustrated in FIG. 6. Therefore, the external contact pin 3 and the tube 2 are in a non-conductive state. On the other hand, when the external contact pin 3 is pushed toward one end side and moves in a backward direction by a distance D5 or more, the large diameter portion 33 of the external contact pin 3 comes into contact with an inner peripheral surface of the insertion portion 21, and the external contact pin 3 and the tube 2 are switched to a conductive state.

### (Third Modification of Third Embodiment)

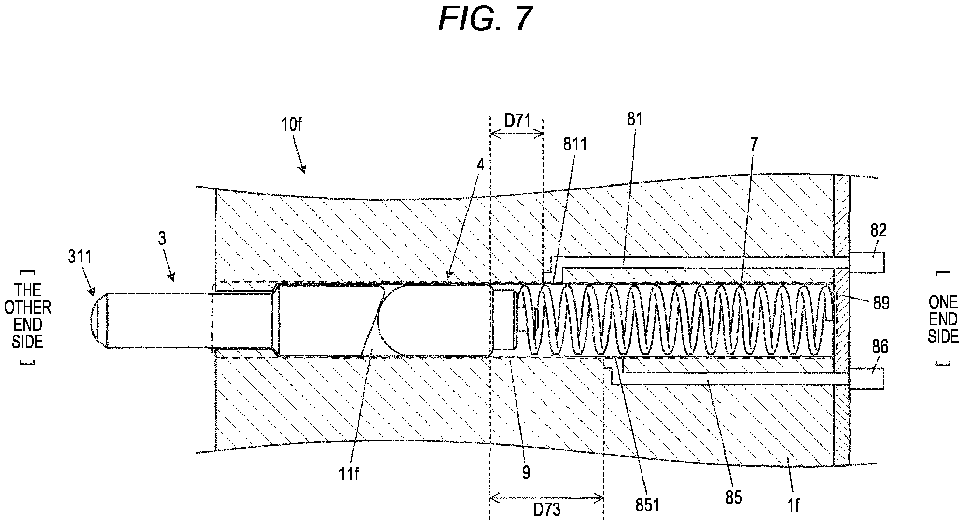

FIG. 7 is a longitudinal cross-sectional view illustrating a configuration example of a spring connector 10f according to a third modification of the third embodiment, and illustrates a spring connector 10f in a state where the external contact pin 3 protrudes (the external contact pin 3 is at a non-pushed-in position). The spring connector 10f includes wirings 81, 85 instead of the tube 2 of the third embodiment. Further, the internal contact 4 of the first embodiment is provided instead of the internal contact pin 41b of the third embodiment.

As illustrated in FIG. 7, the spring connector 10f includes a housing 1f, the external contact pin 3, the internal contact 4, and the spring 7.

Since the tube 2 is not present, a step is not provided on one end side of a through hole 11f of the housing 1f. Therefore, the through hole 11f forms the internal space 9.

The wiring 81, 85 are connected to respective terminals 82, 86 provided outside a resin cover portion 89 that covers one end side of the spring connector 10f.

Most of the wiring 81 is embedded in the housing 1f, a tip end portion 811 is exposed to an inner peripheral surface of the through hole 11f, and a distal end portion on one end side is connected to the terminal 82. A position of the tip end portion 811 is determined to be a position at which the internal contact 4 and the tip end portion 811 come into contact with each other when the internal contact 4 moves in a backward direction by a distance D71.

Most of the wiring 85 is embedded in the housing 1f, a tip end portion 851 is exposed to the inner peripheral surface of the through hole 11f, and a distal end portion on one end side is connected to the terminal 86. A position of the tip end portion 851 is determined to be a position at which the internal contact 4 and the tip end portion 851 come into contact with each other when the internal contact 4 moves in the backward direction by a distance D73. The distance D73 is longer than the distance D71.

The external contact pin 3, the wirings 81, 85, and the terminals 82, 86 are in a non-conductive state when the external contact pin 3 is in a non-pushed-in state. When the external contact pin 3 moves from the non-pushed-in position by the distance D71, the internal contact 4 comes into contact with the tip end portion 811 of the wiring 81, the external contact pin 3, the wiring 81, and the terminal 82 are switched to a conductive state. Further, when the external contact pin 3 moves in the backward direction by the distance D73, the internal contact 4 comes into contact with the tip end portion 851 of the wiring 85, and the external contact pin 3, the wiring 85, and the terminal 86 are switched to the conductive state.

When the external contact pin 3 moves in the backward direction by the distance D73, the external contact pin 3, the wiring 81, and the terminal 82 may be brought into the non-conductive state as follows. That is, lengths of the wirings 81, 85 and the positions of the tip end portions 811, 851 may be adjusted such that a distance difference between the distance D73 and the distance D71 is longer than a length of the internal contact 4 in the axial direction (a left-right direction in FIG. 7).

When the external contact pin 3 moves in the backward direction by the distance D73, if it is desired to keep the conductive state between the external contact pin 3, the wiring 81, and the terminal 82, the following operation may be performed. That is, the lengths of the wirings 81, 85 and the positions of the tip end portions 811, 851 may be adjusted such that the distance difference between the distance D73 and the distance D71 is shorter than the length of the internal contact 4 in the axial direction (the left-right direction in FIG. 7).

According to the spring connector 10f, it is possible to sequentially switch the external contact pin 3, the wirings 81, 85, and the terminals 82, 86 from the non-conductive state to the conductive state in accordance with the movement of the external contact pin 3 in the backward direction.

The third modification can be further modified into the following modes. In one modification, the spring 7 is the insulating spring 7a, and the internal contact pin 4 is the internal contact pin 41a. According to this modification, the other end side of the spring 7a has the same configuration as that of the second embodiment.

In another modification, the spring 7 is the insulating spring 7a, and the internal contact pin 4 is the metal ball 5c. According to this modification, the other end side of the spring 7a has the same configuration as that of the third embodiment.

In another modification, the spring 7 is the insulating spring 7a, and the internal contact pin 4 is omitted. According to this modification, the other end side of the spring 7a has the same configuration as that of the first modification of the third embodiment.

### (Fourth Embodiment)

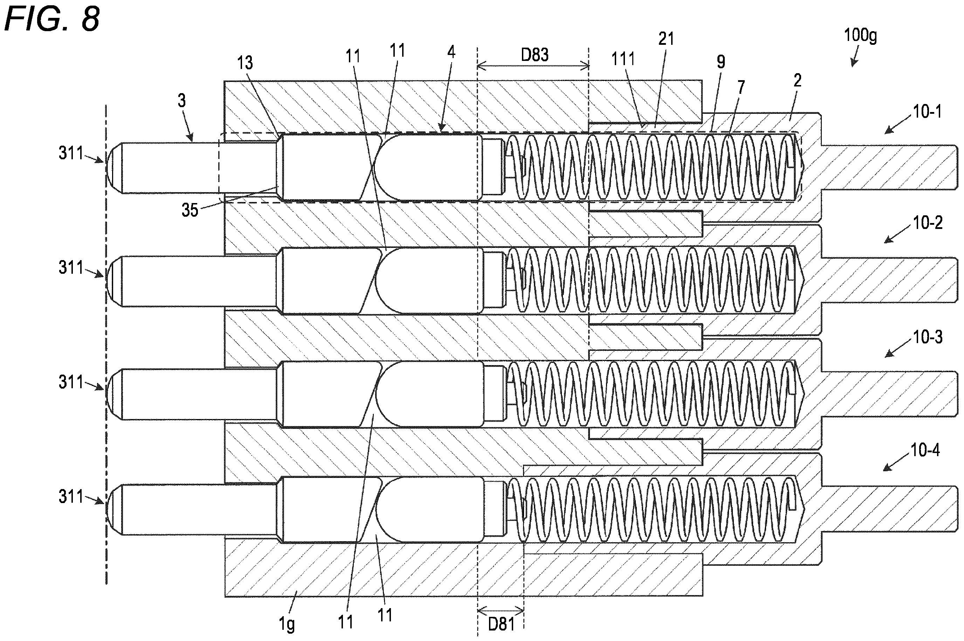

In each of the above-described embodiments, a single spring connector has been described, but a connector including a plurality of spring connectors can also be configured. FIG. 8 is a longitudinal cross-sectional view illustrating a connector 100g of a fourth embodiment. In FIG. 8, the connector 100g including four spring connectors 10 (10-1, 10-2, 10-3, and 10-4) of the first embodiment is illustrated, and each spring connector 10 is illustrated as a state where the external contact pin 3 thereof is at a non-pushed-in position. The connector 100g is used in, for example, a cradle for electronic device connection, and is used by detachably connecting a group of terminals of an electronic device to be connected. Hereinafter, this connection is referred to as "connector connection". At the time of connector connection, the group of terminals to be connected is pushed against the tip end portion 311 of each external contact pin 3, whereby the tip end portions 311 are pushed, and the external contact pins 3 are pushed into the respective through holes 11. In FIG. 8, the same components as those of the first embodiment are denoted by the same reference signs.

As illustrated in FIG. 8, the connector 100g of the fourth embodiment includes an insulating housing 1g in which the housings 1 (see FIG. 1) are integrally formed when each spring connector 10 is configured as a single body. The housing 1g has the plurality of through holes 11 formed in accordance with the arrangement of the spring connectors 10 (the arrangement of the group of terminals to be connected). In the example of FIG. 8, four through holes 11 are formed in a row at predetermined intervals in the housing 1g.

The connector 100g has the plurality of spring connectors 10 whose movement amounts in the backward direction for switching the conductive state between the external contact pin 3 and the tube 2 are different. In the example of FIG. 8, a movement amount D81 of the lowermost spring connector 10-4 is set to be shorter than a movement amount D83 of the other three spring connectors 10-1, 10-2, and 10-3. The spring connector 10-4 is for ground connection, and the other three spring connectors 10-1, 10-2, and 10-3 are for signal transmission and power supply. The arrangement (pin arrangement) of the spring connector 10 for ground connection, the spring connector 10 for signal transmission, and the spring connector 10 for power supply is determined in advance in relation to the group of terminals to be connected. The spring connectors 10 having different movement amounts for switching the conductive state are provided at positions corresponding to the pin arrangement.

Although it has been described that the spring connectors 10-1, 10-2, and 10-3 are for signal transmission and power supply and the spring connector 10-4 is for ground connection, the present invention is not limited thereto, and the number of spring connectors for ground connection, power supply, and signal transmission may each be one or more.

According to the connector 100g of the fourth embodiment, it is possible to perform sequence control for controlling an order of electrical connection between each spring connector 10 and the terminal to be connected at the time of connector connection. In the example of FIG. 8, when the electronic device to be connected is to be connected to the connector 100g, first, the external contact pin 3 and the tube 2 of the spring connector 10-1 for ground connection can be switched to a conductive state. Thereafter, the external contact pins 3 of the spring connectors 10-2, 10-3, and 10-4 for signal transmission and the tubes 2 can be switched to the conductive state. On the other hand, when the electronic device connected to the connector is detached from the connector 100g, first, the external contact pins 3 of the spring connectors 10-2, 10-3, and 10-4 for signal transmission and the tubes 2 can be switched to the non-conductive state. Thereafter, the external contact pin 3 of the spring connector 10-1 for ground connection and the tube 2 can be switched to the non-conductive state.

In the configuration in the related art in which the external contact pin, the spring, and the like are accommodated in the conductive tube, as described above, the external contact pin and the tube are always in contact with each other, and electrical connection is performed even not in the connector connection, i.e., when the connector is not in use. Therefore, when it is necessary to perform the sequence control as described above, by changing the length of the tip end portion (an protruding amount of the external contact pin 3 from the other end of the through hole 11 when the external contact pin 3 is positioned at the non-pushed-in position), when the connector is connected, each terminal of the electronic device to be connected is devised to come into contact with a corresponding tip end portion in a desired order. For example, the external contact pin of the spring connector for ground connection may have a large protruding amount, and the external contact pin of the spring connector for signal transmission may have a small protruding amount. However, in this configuration, the appearance is poor since the positions of the tip end portions are not aligned. Further, when a terminal portion of the electronic device to be connected is inclined with respect to the connector and the connector is connected, each spring connector may not be conducted in a correct conduction order, and malfunction may occur.

On the other hand, in the configuration of the fourth embodiment, as indicated by a one-dot chain line in FIG. 8, it is possible to realize the connector including a mixture of the spring connectors 10 having different movement amounts related to the switching of the conductive state while aligning positions of the tip end portions 311 (the protruding amounts of the external contact pins 3). A height of the spring connector 10 can be easily increased as described above, and a stroke length of the external contact pin 3 can be easily increased. The movement amount can be adjusted by changing the position of the switching boundary in the above-described manner. Therefore, it is possible to improve the appearance. Further, when the tip end portion 311 is not pushed, the external contact pin 3 and the tube 2 are brought into the non-conductive state, and the conduction order of the spring connectors 10 can be defined by the movement amount of each external contact pin 3 (the position of the switching boundary), so that the occurrence of the above-described malfunction can be suppressed.

Further, since the tube 2 can be attached to the housing 1 by inserting the insertion portion 21 into the through hole 11, a narrower pitch can be realized as compared with a case where a connector is configured by arranging the spring connectors having a configuration in the related art in which the external contact pin, the spring, and the like are accommodated in the conductive tube.

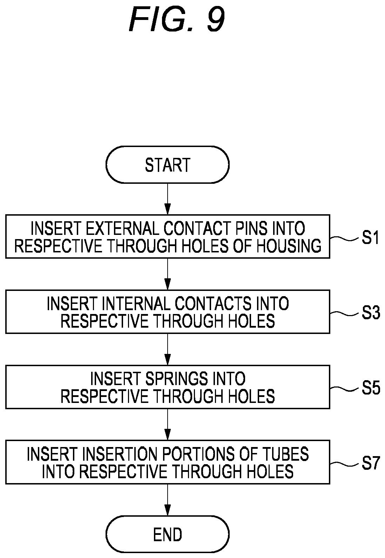

Next, a method for manufacturing the connector 100g will be described. FIG. 9 is a flowchart illustrating the method for manufacturing the connector 100g. As illustrated in FIG. 9, in order to assemble the connector 100g, first, the external contact pins 3 are inserted into the plurality of (here, four) through holes 11 of the housing 1g, respectively (step S1). As in the first embodiment, the step surface 35 abuts on the step 13 of the through hole 11, so that the external contact pin 3 is suppressed from coming off. Subsequently, after the external contact pins 3 are inserted, the internal contacts 4 are inserted into the through holes 11, respectively (step S3). Subsequently, after the internal contacts 4 are inserted, the springs 7 are inserted into the through holes 11, respectively (step S5).

Subsequently, after the springs 7 are inserted, the insertion portions 21 of the tubes 2 are inserted into the through holes 11, respectively, and the insertion portions 21 are pushed and fitted until end surfaces of the insertion portions 21 come into contact with steps of the first step portions 111 (step S7). Accordingly, the insertion portion 21 is positioned between the spring 7 and the through hole 11, and the internal space 9 is formed.

Similarly, in a case where the spring connectors 10a, 10b, 10c, 10d, and 10e according to any one of the second and third embodiments are applied to form a connector, the connector is assembled by inserting the components into the through holes 11 in order from the external contact pins 3.

The connector 100g can be easily assembled by inserting the external contact pins 3, the internal contacts 4, the springs 7, and the insertion portions 21 of the tubes 2 in order into the housing 1g provided with the plurality of through holes 11. More specifically, manufacturing processing can be simplified because the process of crimping the tip end of the tube is not required as in the first embodiment. Further, since the crimping portion of the tube is eliminated, mechanical strength is improved.

Although the plurality of embodiments and manufacturing methods have been described above, the present invention is also applicable to embodiments and methods other than the above-described embodiments and manufacturing methods. For example, the present invention can also be applied to the following modifications.

For example, in the spring connector 10 of the first embodiment, as illustrated in FIG. 2, the external contact pin 3 is not in direct contact with the tube 2. Alternatively, the external contact pin 3 and the tube 2 may be in direct contact with each other at the backward position. This can be realized by defining dimensions of the respective portions such that a rear end side (one end side) of the external contact pin 3 is positioned inside the insertion portion 21 at the backward position of the external contact pin 3.

Further, when the external contact pin 3 and the tube 2 are brought into the conductive state by direct contact, the internal contact 4 including the internal contact pin 41 may be insulating.

Several embodiments and modifications thereof have been described. The disclosure of the present specification can be summarized as follows.

According to an aspect of the present disclosure, there is provided a spring connector including: an insulating housing having a through hole; a conductor disposed on one end side of the through hole; and a conductive external contact pin disposed on another end side of the through hole. The housing has an opening portion on the other end side of the through hole. A part of the through hole and a part of the conductor form an internal space. The external contact pin includes a tip end portion configured to protrude from the opening portion and a main body portion positioned in the through hole. The external contact pin and the conductor are configured to be switched between a non-conductive state and a conductive state by moving the tip end portion of the external contact pin in a backward direction opposite to a protruding direction in which the tip end portion protrudes from the opening portion.

According to this aspect, when the external contact pin moves in the backward direction, the external contact pin and the conductor are switched between the non-conductive state and the conductive state. Therefore, it is possible to provide a technique of the spring connector capable of cutting off electrical connection when the external contact pin is not pushed and capable of performing the electrical connection when the external contact pin is pushed. Further, since the electrical connection is cut off when the external contact pin is not pushed, conduction does not occur when conductive foreign matter comes into contact with the external contact pin, and safety can be improved.

The conductor may be a conductive tube. The tube may include a tubular insertion portion. A part of the insertion portion may form a part of the internal space.

Accordingly, since the internal space is formed by the part of the through hole of the housing and the part of the insertion portion of the tube, a length of the tube itself can be made shorter than a length of a tube in the related art. Hole machining for forming the insertion portion and plating processing on a peripheral surface without the insertion portion can be facilitated, and the workability of the tube can be improved. Surface roughness at the time of the hole machining can be improved. Further, it is possible to flexibly cope with an increased height, and it is possible to easily increase the stroke length of the external contact pin.

The conductor may include a wiring and a terminal, and a part of the wiring may form a part of the internal space.

The spring connector may further include an insulating elastic member positioned in the internal space and configured to bias the external contact pin in the protruding direction.

Accordingly, when the external contact pin is not pushed by a predetermined amount, the external contact pin and the conductor are not in direct contact with each other, so that the electrical connection can be cut off, and when the external contact pin is pushed by the predetermined amount, the electrical connection is established.

The spring connector may further include a conductive internal contact portion positioned between the external contact pin and the elastic member and configured to be in contact with the external contact pin by the biasing of the elastic member, and the internal contact portion and the part of the conductor forming the internal space may be configured to be switched between a non-contact state and a contact state in accordance with a movement amount of the external contact pin in the backward direction.

Accordingly, the external contact pin and the conductor can be switched between the non-conductive state and the conductive state according to the movement mount of the external contact pin in the backward direction.

The spring connector may further include an elastic member positioned in the internal space and configured to bias the external contact pin in the protruding direction; a conductive internal contact portion positioned between the external contact pin and the elastic member and configured to be in contact with the external contact pin by the biasing of the elastic member; and an insulator positioned between the internal contact pin and the elastic member.

Accordingly, the internal contact portion and the elastic member are insulated from each other, and conduction between the internal contact portion and the conductor and conduction between the external contact pin and the conductor can be suppressed.

The spring connector may further include an elastic member positioned in the internal space and configured to bias the external contact pin in the protruding direction; and an insulating internal contact portion positioned between the external contact pin and the elastic member and configured to be in contact with the external contact pin by the biasing of the elastic member.

Accordingly, the external contact pin and the elastic member are insulated from each other, and conduction between the external contact pin and the conductor can be suppressed.

A surface of the external contact pin which is configured to be in contact with the internal contact portion may be an inclined surface. Further, the internal contact portion may be a spherical body, or an end portion on a side to be in contact with the external contact pin may be a convex portion.

Accordingly, the number of contact points (internal contact points) at which the internal contact portion and the external contact pin are stably in contact with the inner peripheral surface of the internal space is increased, and a contact posture between the internal contact portion and the external contact pin is stabilized, and reliable contact between the internal contact portion and the external contact pin is maintained. Therefore, the external contact pin and the conductor can be reliably conducted.

The spring connector may further include an elastic member positioned in the internal space and configured to bias the external contact pin in the protruding direction; and an insulator positioned between the external contact pin and the elastic member.

Accordingly, the external contact pin and the elastic member are insulated from each other, and conduction between the external contact pin and the conductor can be suppressed.

According to another aspect, there is provided a connector including a plurality of the spring connectors. Housings of the plurality of spring connectors are integrally made of a resin.

Accordingly, the connector including the plurality of spring connectors having the same effect as described above can be realized. In this case, the housings of the spring connectors can be integrally made of a resin. Further, since the housings are made of a resin, it is possible to realize a narrow pitch.

The connector may include the spring connectors having different movement amounts in the backward direction for switching the conductive state between the external contact pin and the tube.

Accordingly, it is possible to perform sequence control for controlling an order of electrical connection between each spring connector and the terminal to be connected.

The protruding amounts of tip end portions of the plurality of spring connector may be the same.

Accordingly, an appearance can be improved, and an occurrence of malfunction can be suppressed.

According to another aspect of the present invention, there is provided a method for manufacturing a connector including: inserting conductive external contact pins into respective through holes of an insulating housing having the through holes; inserting elastic members after insertion of the external contact pins; and inserting conductive tubes each having a tubular insertion portion on a tip end side such that the insertion portion is positioned between the elastic member and the through hole after insertion of the elastic members.

Accordingly, manufacturing processing can be simplified because a process of crimping the tip end of the tube is not required. Further, since the crimping portion of the tube is not required, a mechanical strength of the connector can be improved.

### REFERENCE SIGNS LIST

10, 10a, 10b, 10c, 10d, 10e, 10f spring connector
1, 1f, 1g housing
11 through hole
2, 2e tube
21, 21e insertion portion
25e insulating area
3 external contact pin
311 tip end portion
4 internal contact
41, 41a, 41b internal contact pin
6 insulator
5c metal ball
7, 7a spring
9 internal space
100g connector

## Claims

1. A spring connector comprising:
an insulating housing having a through hole;
a conductor disposed on one end side of the through hole; and
a conductive external contact pin disposed on another end side of the through hole,
wherein the housing has an opening portion on the other end side of the through hole,
wherein a part of the through hole and a part of the conductor form an internal space,
wherein the external contact pin includes a tip end portion configured to protrude from the opening portion and a main body portion positioned in the through hole, and
wherein the external contact pin and the conductor are configured to be switched between a non-conductive state and a conductive state by moving the tip end portion of the external contact pin in a backward direction opposite to a protruding direction in which the tip end portion protrudes from the opening portion.

2. The spring connector according to claim 1,
wherein the conductor is a conductive tube,
wherein the tube includes a tubular insertion portion, and
wherein a part of the insertion portion forms a part of the internal space.

3. The spring connector according to claim 1,
wherein the conductor includes a wiring and a terminal, and
wherein a part of the wiring forms a part of the internal space.

4. The spring connector according to any one of claims 1 to 3 further comprising:
an insulating elastic member positioned in the internal space and configured to bias the external contact pin in the protruding direction.

5. The spring connector according to claim 4 further comprising:
a conductive internal contact portion positioned between the external contact pin and the elastic member and configured to be in contact with the external contact pin by the biasing of the elastic member,
wherein the internal contact portion and the part of the conductor forming the internal space are configured to be switched between a non-contact state and a contact state in accordance with a movement amount of the external contact pin in the backward direction.

6. The spring connector according to any one of claims 1 to 3 further comprising:
an elastic member positioned in the internal space and configured to bias the external contact pin in the protruding direction;
a conductive internal contact portion positioned between the external contact pin and the elastic member and configured to be in contact with the external contact pin by the biasing of the elastic member; and
an insulator positioned between the internal contact pin and the elastic member.

7. The spring connector according to any one of claims 1 to 3 further comprising:
an elastic member positioned in the internal space and configured to bias the external contact pin in the protruding direction; and
an insulating internal contact portion positioned between the external contact pin and the elastic member and configured to be in contact with the external contact pin by the biasing of the elastic member.

8. The spring connector according to any one of claims 5 to 7,
wherein a surface of the external contact pin which is configured to be in contact with the internal contact portion is an inclined surface, and
wherein the internal contact portion is a spherical body, or an end portion on a side to be in contact with the external contact pin is a convex portion.

9. The spring connector according to any one of claims 1 to 3 further comprising:
an elastic member positioned in the internal space and configured to bias the external contact pin in the protruding direction; and
an insulator positioned between the external contact pin and the elastic member.

10. A connector comprising:
a plurality of the spring connectors according to any one of claims 1 to 9,
wherein housings of the plurality of spring connectors are integrally made of a resin.

11. The connector according to claim 10,
wherein the spring connectors have different movement amounts in the backward direction for switching the conductive state between the external contact pin and the tube.

12. The connector according to claim 11,
wherein protruding amounts of tip end portions of the plurality of spring connectors are the same.

13. A method for manufacturing a connector comprising:
inserting conductive external contact pins into respective through holes of an insulating housing having the through holes;
inserting elastic members after insertion of the external contact pins; and
inserting conductive tubes each having a tubular insertion portion on a tip end side such that the insertion portion is positioned between the elastic member and the through hole after insertion of the elastic members.
